# EUROPEAN PATENT SPECIFICATION

(11) **EP 0 364 551 B1**
(45) Date of publication and mention of the grant of the patent: **25.05.1994**
(21) Application number: 89904061.2
(22) Date of filing: 16.12.1988
(51) Int. Cl.: H05K 1/18

(54) **THERMAL EXPANSION MISMATCH FORGIVABLE PRINTED WIRING BOARD FOR CERAMIC LEADLESS CHIP CARRIER**
EINE DIE THERMISCHE AUSDEHNUNGSUNGLEICHHEIT REDUZIERENDE GEDRUCKTE SCHALTUNGSPLATTE FÜR EINEN KERAMISCHEN DRAHTLOSEN CHIPTRÄGER
CARTE DE CIRCUITS IMPRIMES A DIFFERENCE DE DILATATION THERMIQUE TOLERABLE POUR SUPPORT INTERMEDIAIRE EN CERAMIQUE DU TYPE PLAT

(30) Priority: 21.03.1988 US 171047; 21.03.1988 US 171048
(43) Date of publication of application: 25.04.1990
(73) Proprietor: Hughes Aircraft Company, Los Angeles, California 90045-0066 (US)
(72) Inventor: LO, Ching-Ping, Los Angeles, CA 90045 (US); YEH, Kwang, Huntington Beach, CA 92646 (US); VALLE, Manual, B., Covina, CA 91724 (US)
(74) Representative: KUHNEN, WACKER & PARTNER
(86) International application number: US8804516
(87) International publication number: WO8909534

(56) References cited:
- EP-A- 0 044 247
- EP-A- 0 075 890
- EDN ELECTRICAL DESIGN NEWS, vol. 29, no. 17, 23 August 1984, Boston, Massachusetts, US; R.A.REYNOLDS: "Clad-metal-core pc boards enhance chip-carrier viability", pages 211-215

## Description

### BACKGROUND OF THE INVENTION

### 1. Field of the Invention

The present invention relates to a printed wiring board for mounting a ceramic leadless chip carrier and to a method for forming a printed wiring board and relates generally to the surface mounting of ceramic leadless chip carriers to printed wiring boards. More particularly, the present invention relates to methods and apparatus for increasing the reliability of the solder joint integrity between the printed wiring board and the chip carrier.

### 2. Description of Related Art

From EP-A-0 044 247 a printed wiring board is known comprising a substrate, a patterned layer of adhesive, a patterned metal layer, an electrical component, and connections. The adhesive is patterned to have an opening whose length exceeds that of the component to be soldered. The opening is sufficiently long to permit adaptation to the mechanical and thermal characteristics of the substrate and component.

The surface mounting of electronic devices, such as ceramic leadless chip carriers, has become popular due to the ability to save weight and volume in electronic equipment when such surface-mount technology is used. In addition, the need for increased circuit density makes surface mounting of chip carriers even more desirable.

Typically, the ceramic leadless chip carrier is mounted to the printed wiring board surface by way of solder fillets or joints. It is important that the integrity and reliability of the solder joint be maintained for long periods of time and be able to withstand numerous temperature and power cycles. In addition, the solder joint must be able to withstand shock and vibration which may occur in many electronic systems such as those used in avionics.

The increasing popularity of surface mounting of ceramic leadless chip carriers has brought with it concerns over the reliability and integrity of the solder joints between the chip carriers and the printed wiring board. Cracking and other disturbances to the joint integrity have been noted. Joint cracking is believed to be due mainly to differences in the thermal coefficients of expansion between the printed wiring board and the chip carriers. Various different approaches have been taken to reduce the possibility of solder joint cracking. These approaches have included making the printed wiring board out of materials having thermal coefficients of expansion which are close to the thermal coefficient of expansion for the ceramic leadless chip carriers. In addition, attempts have been made to replace the solder joint with a joint which is less likely to crack, such as electrically conductive epoxy compounds. Although the various approaches used to date have experienced different degrees of success, there still is a continuing need to provide a method for surface mounting ceramic leadless chip carriers to printed wiring boards wherein the possibility of solder joint cracking is eliminated.

### SUMMARY OF THE INVENTION

The present invention in accordance with claims 1 and 12 provides an improved method and apparatus for mounting ceramic leadless chip carriers to printed wiring boards wherein the chances of solder joint cracking are reduced to thereby increase the reliability and integrity of the system.

The present invention is based upon fabricating the printed wiring circuit board so that the top layer of the board expands and contracts with the chip carrier regardless of the expansion or contraction rates of the main body of the wiring board.

The printed wiring board in accordance with claim 1 includes an expansion layer having a bottom surface and top surface wherein the top surface of the expansion layer forms the top surface of the printed wiring board. The expansion layer is supported by a rigid support layer which also has a top and a bottom. The bottom of the expansion layer is bonded to the top of the rigid support layer except in the area located directly below the footprint of the chip carrier and solder joints. This lack of bonding between the expansion layer and rigid support layer provides a forgivable expansion area located underneath the chip carrier footprint wherein the expansion layer can expand and contract the same amount as the chip carrier irrespective of the expansion and contraction rates of the rigid support layers.

The expansion layer is relatively thin and flexible, and the leadless chip carrier solder joint stress caused by thermal expansion mismatch between the leadless chip carrier and the expansion layer is extremely low so that the chances for solder joint cracking are reduced.

A polytetrafluoroethylene (PTFE) dispersion or emulsion may be applied onto the bottom of the expansion layer at those locations where bonding is not desired. The PTFE dispersion is then dried and cured to form non-bonding areas. Subsequent bonding of the expansion layer to the rigid support layer provides bonding everywhere except at the non-bonding locations provided by the PTFE layer.

Conventional mold release systems do not work well with the adhesives (such as polyimide prepreg) that are typically used to bond layers together in laminated circuit boards. The PTFE aqueous dispersion, on the other hand, works well with many adhesives. The cured PTFE layer also will survive the vapor phase soldering condition which is a required step in the component placement operation. In addition, the use of a cured PTFE dispersion as the release agent is cost effective and can be easily adapted to high volume production.

The above-described features and attendant advantages of the present invention will become better understood by reference to the following description when considered in conjunction with the accompanying drawings.

### BRIEF DESCRIPTION OF THE DRAWINGS

In the accompanying drawings:
FIG. 1 is a perspective view of a printed wiring board prior to mounting of the ceramic leadless chip carriers.
FIG. 2 is a cross-sectional view of the printed wiring board with a leadless ceramic chip carrier soldered thereon in accordance with a first embodiment of the present invention.
FIG. 3 is a cross-sectional view of the printed wiring board with a leadless ceramic chip carrier soldered thereon in accordance with an alternative embodiment of the present invention.

### DESCRIPTION OF THE PREFERRED EMBODIMENTS

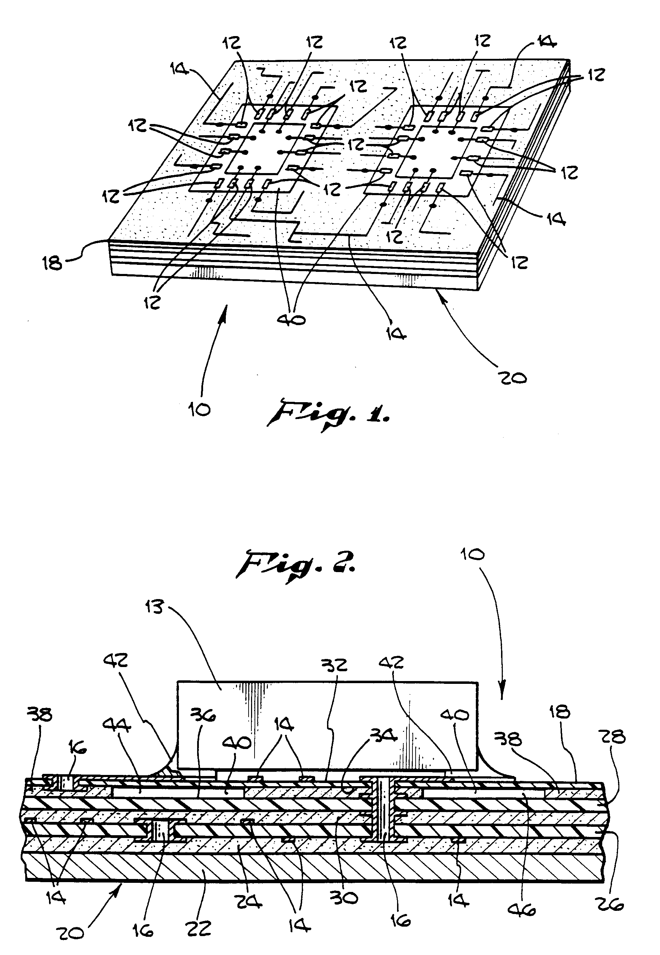

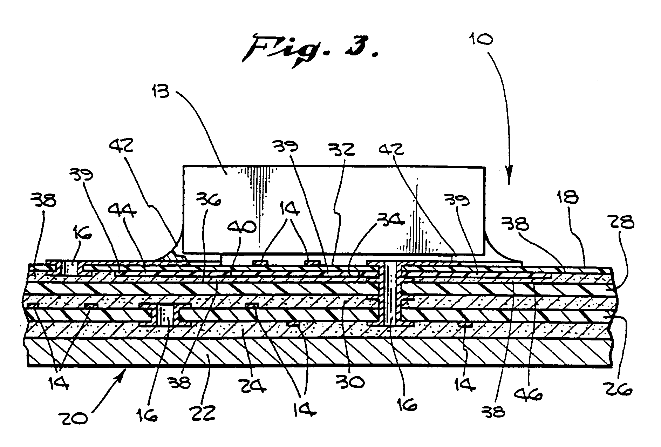

A preferred printed wiring board in accordance with the present invention is shown generally at 10 in FIGS. 1, 2 and 3. The printed wiring board 10 is shown in FIG. 1 prior to mounting of the ceramic leadless chip carriers. The board 10 includes a plurality of chip carrier mounting pads 12. Circuit lines connecting the various circuitry are shown at 14. Via holes are shown at 16. The circuit lines and via holes are provided for illustration purposes only since these are conventional features of any printed wiring board and do not form a part of the invention. A detailed sectional view of a portion of the printed wiring board 10 is shown in FIG. 2 after the ceramic leadless chip carrier 13 is mounted thereon.

The preferred printed wiring board includes an expansion layer 18 which is bonded to a rigid support layer shown generally at 20. The support layer 20 is a multi-layer laminated board, which as best shown in FIG. 2, includes a metal plate 22, thermally conductive adhesive layer 24, and polyimide impregnated glass fiber layers 26 and 28 (referred to herein as polyimide fiberglass) which are bonded together by adhesive layer 30. The metal plate 22 is optional. As is well known, metal plates are included as part of a printed wiring board where it is desirable to thermally conduct heat away from the printed wiring board and where added strength is desired. If a metal plate 22 is used, it is desirable to use a thermally conductive adhesive 24 in order to ensure that heat from the printed wiring board is conducted to the metal plate 22.

The polyimide fiberglass layers 26 and 28 do not necessarily have to be made of polyimide fiberglass. Other suitable printed wiring board materials, such as epoxy fiberglass, polyimide quartz fibers, alumina (ceramic) fiber substrates, polyimide aramid fibers and any other suitable composite materials typically used in printed wiring boards can also be used as the printed wiring board layers. The adhesive layer 30 which is used to bond the layers 26 and 28 together may also be any of the conventionally known adhesives commonly used in preparing laminated printed wiring boards. Examples of suitable adhesives include epoxy prepreg, polyimide prepreg, etc.

When a metal layer 22 is used, it will preferably have a thickness of between about 0.076 cm to 0.76 cm (0.030 inch to 0.300 inch), most preferably between about 0.13 cm to 0.76 cm (0.050 inch to 0.300 inch). The polyimide fiberglass layers 26 and 28 preferably have thicknesses of between about 0.010 cm to 0.64 cm (0.004 inch to 0.25 inch), most preferably to 0.23 cm (0.090 inch). The thickness of the two adhesive layers 24 and 30 are preferably between about 0.010 cm to 0.030 cm (0.004 inch to 0.012 inch). The particular metal used for the metal layer can be any of those conventionally used in printed wiring boards including aluminum, copper and copper alloys and any other suitable thermally conductive metal.

In conventional printed wiring boards, the ceramic leadless chip carrier would be attached directly to the laminated support layer 20. However, in accordance with the present invention, an expansion layer 18 is provided. The expansion layer 18 includes a top 32 and bottom 34. The bottom 34 of expansion layer 18 is bonded to the top 36 of the support layer 20 by way of adhesive layer 38. As best shown in FIG. 2, the adhesive layer 38 is not bonded to the expansion layer 18 underneath the chip carrier 13. This leaves an unbonded area 40 where the expansion layer 18 is not attached to the support layer 20. This provides an expansion area wherein the expansion layer 18 is free to expand and contract with chip carrier 13 irrespective of the remainder of the printed wiring board 20. In an alternative embodiment of the present invention, as shown in FIG. 3, and discussed below, a layer of polytetrafluoroethylene (PTFE) 39 is provided which prevents adhesion of the support layer 20 to the expansion layer 18.

As shown in FIGS. 2 and 3, the chip carrier 13 is mounted onto the top 32 of expansion layer 18 by way of solder fillets or joints 42. The area under the chip carrier 13 and solder joints 42 is defined as the footprint of the chip carrier. In accordance with the present invention, the adhesive layer 38 provides no bonding at locations beneath the chip carrier footprint. The area of non-bonding will extend slightly outward from the footprint as best shown at 44 and 46 in FIG. 2. This provides a non-bonded portion of the expansion layer 18 which does not lie directly beneath the chip carrier footprint. It is essential that this extra non-bonded portion be provided.

The expansion layer 18 is made from a material having low modulus of elasticity, such as a polyimide film. A preferred polyimide film is marketed by E. I. DuPont under the trade name KAPTON. Other flexible films are possible so long as they have properties similar to polyimide including high temperature stability and good bonding characteristics. These films should not contain fillers, such as glass particles or beads which might adversely affect the flexibility of the film.

The thickness of the expansion layer should be such that it has some degree of flexibility while still being structurally strong. Layer thicknesses of between 0.001 cm to 0.013 cm (0.0005 inch to 0.005 inch) are suitable. Suitable adhesives for attaching the expansion layer 18 to the support layer 20 include no-flow type adhesives such as polyimide prepreg, epoxy prepreg, etc. The thickness of the adhesive layer should be less than about 0.25 cm (0.10 inch).

Polyimide films are preferred for use as the expansion layer because polyimide sheeting can be made in very thin sheets while being structurally strong. Further, the modulus of elasticity for polyimide films are very low (4.6 x 10⁵ psi = 0,32·10¹⁰ Pa). Accordingly, the stretching or shrinking of the thin expansion layer under the chip carrier will cause very low stress on the solder joints 42. This stress will be substantially below the fatigue stress of the solder joint. Therefore, the solder joint will not develop cracks.

Any suitable fabrication technique can be utilized in order to insure that the expansion layer 18 is not bonded to the top 36 of support layer 20 at locations under the chip carrier footprint. For example, the unbonded footprint area 40 can be achieved by die cutting the prepreg adhesive layer or by applying various mold release agents on the bottom 34 of expansion layer 18 to prevent the adhesive 38 from adhering to the area below the chip carrier. In addition, layers or sheets of conventional release materials may be inserted between the expansion layer bottom 34 and the top 36 of support layer 20.

In accordance with an alternative embodiment of the present invention, the unbonded footprint area 40 is provided by applying a thin layer of an emulsion of polytetrafluoroethylene (PTFE) to the bottom 34 of expansion layer 18. The PTFE emulsion is dried and then fused at high temperature to provide a well defined PTFE layer 39 which prevents the adhesive layer 38 from bonding to the expansion layer bottom 34.

The PTFE emulsion is preferably an aqueous suspension of very fine PTFE particles. The particle sizes are preferably between about 0.1 to 0.25 µm (microns). The emulsion is preferably applied by silkscreening onto the expansion layer bottom 34. The concentration of PTFE in the aqueous emulsion should be between 55-75 percent by weight depending upon the pore size of the silkscreen used. A PTFE concentration of about 65 weight percent was found to work well when silkscreens having a pore size of 325 mesh are used. The silkscreening process is carried out according to conventional silkscreening techniques which are well known.

Although it is not absolutely necessary, it is preferred that the PTFE particles include a coating of wetting agent to help maintain an aqueous emulsion of the particles. PTFE particles having a wetting agent coating are available from DuPont Chemical Corp. as TEFLON 120-FEP Dispersion. The identity of the wetting agent used on the TEFLON 120 particles is not known; however, it is believed that any known wetting agent can be used provided that it produces the desired emulsion characteristics and can be evaporated by heating or otherwise removed from the PTFE prior to or during fusion.

As an example of practice, a 65 weight percent aqueous emulsion of TEFLON 120-FEP Dispersion was prepared. The solution was selectively silkscreened onto a flexible polyimide sheet using a 325 mesh silkscreen. The emulsion was dried at 125°C for 30 minutes followed by baking at 260°C (500°F) to remove the coating of wetting agent. The remaining PTFE particles were then fused at 274°C (525°F) to form a solid well-defined layer of PTFE.

The PTFE layer prevents the adhesive layer from bonding to the flexible polyimide sheet at the PTFE layer locations when the flexible sheet is bonded to the circuit board as previously described. The PTFE should be relatively pure. However, minor amounts of impurities or additives are possible provided that the non-bonding characteristics of the PTFE relative to the adhesive layer are not lost.

The PTFE particles may also be selectively applied by spraying or other techniques that can provide the same well-defined surface application provided by silk-screening of aqueous emulsions. Methyl ethyl ketone (MEK) and other suitable solvents can be used for spray application provided that they do not flash off too quickly when the emulsion is sprayed. Acetone does not work well as a solvent or carrier for the PTFE particles for spraying or silkscreening because it flashes off too quickly. The final PTFE layer 39, after fusion, should be as thin as possible while still preventing bonding between the flexible expansion layer 18 and support layer 20. PTFE layer thicknesses on the order of 0.0002 cm to 0.0006 cm (0.0001 inch to 0.0003 inch) are preferred.

The temperature for fusion of the particles should be around 274°C (525°F) or higher. Temperatures above 282°C 540°F are preferred because it reduces the time required for fusion of the particles into a thin layer. In addition, it should be noted that the PTFE emulsion may be applied to the support layer 28 instead of the expansion layer 18. In either case, the fused PTFE layer will prevent bonding between the expansion layer 18 and support layer 28 when the adhesive is applied. However, it is preferred to apply the PTFE emulsion to the expansion layer 18.

Tests were conducted on leadless ceramic chip carriers (LCCC) as shown in FIGS. 2 and 3 wherein the LCCC size was 84 I/O, 50 mil center. The LCCC's included a polyimide glass printed wiring board (PWB) assembly which was 0.24 cm (0.09 inch) thick. The expansion layer was flexible polyimide sheet made by Enka having a thickness of 0.002 cm (0.001 inch). A vibration test was performed. The purpose of this test was to find out whether any damage would occur under vibration in the following areas: the LCCC solder joint, the thin flexible expansion layer in the unbonded area, and the PWB itself. The test results showed that this PWB could take high vibration input without any damage.

Ordinarily, the LCCC solder joints of more rigid PWBs have a better chance for surviving the vibration test because rigid boards have a high resonance frequency. When the PWB is resonant, the solder joints of the LCCC have high stresses. If the natural frequency of the PWB is higher than the electronic system's operating vibration frequency (fans, motors, etc.), the vibration will have a minimum effect on the reliability of the PWBs. When the PWB is resonant, it vibrates in a waveform. This waveform tends to pull the PWB away from the LCCC causing high stress on its solder joint.

The compliant-layer PWB of the present invention does not have very high rigidity if no heat sink is used. However, the compliant-layer PWB functions differently from regular PWBs. The thin, flexible, top layer tolerates placement mismatch between the LCCC and the PWB because the thin layer can stretch or compress without creating high stress on the solder joint. This provides a solution to the solder joint failure (due to vibration) of the surface mount device.

Power cycling tests were also performed. All of the compliant-layer PWBs were tested at their worst condition. First, the PWBs were cooled down to -55°C. Then, each LCCC was heated up by chip resistors which were bonded on the LCCCs. The 84-I/O LCCCs used three resistors which dissipated 4.5 watts, the 68-I/O LCCCs used two resistors which dissipated 3 watts, and the 48-I/O LCCCs used one resistor which dissipated 1.5 watts. The PWBs were tested for 1,200 cycles, and none of the solder joints was cracked.

In addition, thermal shock tests were performed. The test procedure was as follows. All of the PWBs were placed into a thermal shock machine. These boards were alternately shifted from a hot chamber to a cold chamber and vice versa. The temperature of the hot chamber was +125°C, and the cold chamber was -55°C. The duration of the PWBs stay in each chamber was 20 minutes.

After a 2,000-cycle thermal shock test, there were no solder joint failures. All of the solder joints looked the same as before the test.

To measure the thermal impedance of the PWBs, the chip resistors were bonded on the center cavity of the LCCCs. It had the same arrangement as the one used for power cycling. The thermocouples were mounted in the LCCC cavity on the LCCC wall, and on the PWB. The power consumption of each LCCC and the temperature of each thermocouple were measured. The thermal impedance of the PWB was calculated. The test results showed that the compliant-layer PWB had the same thermal character as the regular polyimide glass PWB.

## Claims

1. A printed wiring board for mounting a ceramic leadless chip carrier (13), said ceramic leadless chip carrier (13) including a bottom which is attached to the top surface of said printed wiring board (10), wherein the area on the top surface of said printed wiring board (10) under the location where said ceramic leadless chip carrier bottom is attached thereto defines a chip carrier footprint, and wherein said ceramic leadless chip carrier (13) undergoes expansion and contraction, said printed wiring board (16) comprising:
an expansion layer (18) made from a flexible film and having a bottom surface (34) and a top surface (32) wherein the top surface (32) of said expansion layer (18) forms the top surface of said printed wiring board (10);
a rigid support layer (20) having a bottom and a top surface (36), said expansion layer (18) extending substantially over the entire top surface of said support layer (20); and
an adhesive layer (38) located between said expansion layer bottom surface (34) and said support layer top surface (36) for bonding said expansion layer bottom to said support layer top wherein voids (40) are provided in said adhesive layer (38) under said chip carrier footprint so that said expansion layer bottom surface (34) is bonded to said support layer top surface (36) except in the area located below said chip carrier footprint to thereby allow said expansion layer (18) to expand and contract with said ceramic leadless chip carrier (13) during expansion or contraction thereof irrespective of said support layer (20).

2. A printed wiring board according to claim 1 wherein said expansion layer (18) comprises a thin film of polyimide.

3. A printed wiring board according to claim 1 or 2 wherein said expansion layer (18) is 0.001 cm to 0.013 cm (0.0005 inch to 0.005 inch) thick.

4. A printed wiring board according to claim 1, 2 or 3 wherein said expansion layer is a flexible polyimide.

5. A printed wiring board according to one of the previous claims wherein said support layer (20) comprises a plurality of sub-layers laminated together.

6. A printed wiring board according to claim 5 wherein said sub-layers comprise metal, glass, ceramics or rigid plastic.

7. A printed wiring board according to claim 1 wherein said adhesive layer comprises an adhesive selected from the group consisting of polyimide prepreg and epoxy prepreg.

8. A printed wiring board according to claim 7 wherein said adhesive layer is less than 0.25 cm (0.10 inch) thick.

9. A printed wiring board according to one of the previous claims further including a ceramic leadless chip carrier (13) and mounting means (42) for attaching said ceramic leadless chip carrier (13) to the top surface (32) of said expansion layer (18) and wherein expansion and contraction of said expansion layer (18) with the expansion and contraction of said ceramic leadless chip carrier (13) prevents cracking of said mounting means (42).

10. A printed wiring board according to one of the previous claims further including a thin layer (39) of polytetrafluoroethylene located between said expansion layer bottom surface (34) and said printed wiring board top surface (36) at said chip carrier footprint (40), said layer (39) of polytetrafluoroethylene being positioned so that said adhesive means (38) does not bond to said expansion layer bottom (34) under said chip carrier footprint (40).

11. A printed wiring board according to claim 10 wherein said thin layer (39) of polytetrafluoroethylene has a thickness of between 0.0002 cm to 0.0006 cm (0.0001 inch to 0.0003 inch).

12. A method for forming a printed wiring board (10) for mounting a ceramic leadless chip carrier (13) comprising the steps of:
preparing a rigid support layer (20) having a bottom and a top surface (36);
preparing an expansion layer (18) made from a flexible film and having a bottom surface (34) and a top surface (32) wherein the top surface (32) of said expansion layer (18) forms the top surface of said printed wiring boarding (10), and wherein an adhesive layer (38) is located between said expansion layer bottom surface (34) and said support layer top surface (36) for bonding said expansion layer bottom to said support layer top, said expansion layer (18) extending substantially over the entire top surface of said support layer (20);
forming a thin layer (39) of polytetrafluoroethylene by applying an aqueous emulsion of polytetrafluoroethylene particles to said expansion layer bottom surface (34);
and
heating said emulsion for a sufficient time and at sufficient temperatures to fuse said polytetrafluoroethylene particles into said thin layer (39),
said thin layer being located between said bottom surface (34) and said top surface (36) at a chip carrier footprint (40) which is defined by the area on the top surface of said printed wiring board (10) under the location where said ceramic leadless chip carrier bottom is attached thereto, said thin layer (39) being positioned such that said adhesive layer (38) bonds to said bottom surface (34) except in the area located below said chip carrier footprint (40).

13. A method according to claim 12 wheren said aqueous emulsion comprises from 55-75 weight percent polytetrafluoroethylene particles.

14. A method according to claim 12 or 13 wherein said polytetrafluoroethylene particles include a surface coating of a wetting agent.

15. A method according one of claims 12-14 wherein the particle size of said polytetrafluoroethylene particles is between 0.1 µm to 0.25 µm.

16. A method according to one of the claims 12-15 wherein said aqueous emulsion of polytetrafluoroethylene particles is selectively applied to said expansion layer bottom surface (34) by silkscreening.

17. A method according to one of the claims 12-16 wherein said thin layer (39) of fused polytetrafluoroethylene has a thickness of between 0.0002 cm to 0.0006 cm (0.0001 inch to 0.0003 inch).

## Patentansprüche

1. Gedruckte Verdrahtungsplatine für die Anbringung eines anschlußlosen Chipträgers (13) aus Keramik, wobei der anschlußlose Chipträger (13) aus Keramik einen an der Oberseite der gedruckten Verdrahtungsplatine (10) befestigten Boden aufweist, wobei die Fläche auf der Oberseite der gedruckten Verdrahtungskarte (10) unterhalb der Position, an der der Boden des anschlußlosen Chipträger (13) angebracht ist eine Chipträgerabdruckfläche definiert und der anschlußlose Chipträger (13) aus Keramik einer Ausdehnung und Kontraktion unterliegt, wobei die gedruckte Verdrahtungsplatine (16) aufweist:
eine aus einem flexiblen Film hergestellte Expansionsschicht (1) mit einer Bodenfläche (34) und einer Oberseite (32), wobei die Oberseite (32) der Expansionsschicht (18) die Oberseite der gedruckten Verdrahtungsplatine (10) bildet;
eine unelastische Auflageschicht (20) mit einem Boden und einer Oberseite (36), wobei sich die Expansionsschicht (18) im wesentlichen über die gesamte Oberseite der Auflageschicht (20) erstreckt; und
eine zwischen der Bodenfläche (34) der Expansionsschicht und der Oberseite (36) der Auflageschicht angeordnete Haftschicht (38) zum Bonden des Expansionsschichtbodens mit der Oberseite der Auflageschicht, bei der Leerräume (40) in der Haftschicht (38) unterhalb der Chipträgerabdruckfläche vorgesehen derart sind, daß die Bodenfläche (34) der Expansionsschicht mit Ausnahme des unterhalb der Chipträgerabdruckfläche befindlichen Bereichs mit der Oberseite (36) der Auflageschicht gebondet ist, um der Expansionsschicht (18) zu ermöglichen, sich zusammen mit dem anschlußlosen Chipträger (13) aus Keramik bei dessen Ausdehnung und Kontraktion unabhängig von der Auflageschicht (20) auszudehnen und zu kontrahieren.

2. Gedruckte Verdrahtungsplatine nach Anspruch 1, dadurch gekennzeichnet, daß die Expansionsschicht (18) einen dünnen Film aus Polyimid aufweist.

3. Gedruckte Verdrahtungsplatine nach Anspruch 1 oder 2, dadurch gekennzeichnet, daß die Expansionsschicht (18) 0,001 cm bis 0,013 cm (0,0005 Zoll bis 0,005 Zoll) dick ist.

4. Gedruckte Verdrahtungsplatine nach Anspruch 1, 2 oder 3, dadurch gekennzeichnet, daß die Expansionsschicht (18) aus einem flexiblen Polyimid besteht.

5. Gedruckte Verdrahtungsplatine nach einem der vorstehenden Ansprüche, dadurch gekennzeichnet, daß die Auflageschicht (20) eine Vielzahl von aneinander laminierten Einzelschichten aufweist.

6. Gedruckte Verdrahtungsplatine nach Anspruch 5, dadurch gekennzeichnet, daß die Einzelschichten Metall, Glas, Keramik oder starres Plastik aufweisen.

7. Gedruckte Verdrahtungsplatine nach Anspruch 1, dadurch gekennzeichnet, daß die Haftschicht ein Haftmittel aufweist, welches aus der aus Polyimid-Prepreg und Epoxy-Prepreg bestehenden Gruppe gewählt ist.

8. Gedruckte Verdrahtungsplatine nach Anspruch 7, dadurch gekennzeichnet, daß die Haftschicht dünner als 0,25 cm (0,10 Zoll) ist.

9. Gedruckte Verdrahtungsplatine nach einem der vorstehenden Ansprüche, welche des weiteren einen anschlußlosen Chipträger (13) aus Keramik und Anbringungsmittel (42) zur Befestigung des anschlußlosen Chipträgers (13) aus Keramik an der Oberseite (32) der Expansionsschicht (18) aufweist, und bei der ein Zerbrechen der Befestigungsmittel (42) dadurch verhindert ist, daß sich die Expansionsschicht (18) und der anschlußlose Chipträger (13) aus Keramik gemeinsam ausdehnen und kontrahieren.

10. Gedruckte Verdrahtungsplatine nach einem der vorstehenden Ansprüche, welche des weiteren an der Chipträgerabdruckfläche (40) eine zwischen der Bodenfläche (34) der Expansionsschicht und der Oberseite (36) der gedruckten Verdrahtungsplatine angeordnete dünne Schicht (39) aus Polytetrafluorethylen aufweist, die derart angeordnet ist, daß das Haftmittel (38) unterhalb der Chipträgerabdruckfläche (90) nicht an der Unterseite (34) der Expansionsschicht gebondet ist.

11. Gedruckte Verdrahtungsplatine nach Anspruch 10, dadurch gekennzeichnet, daß die dünne Schicht (39) aus Polytetrafluorethylen eine Dicke von 0,0002 cm bis 0,0006 cm (0,0001 Zoll bis 0,0003 Zoll) aufweist.

12. Verfahren zur Herstellung einer gedruckten Verdrahtungsplatine (10) für die Anbringung eines anschlußlosen Chipträgers (13) aus Keramik, welches die Schritte aufweist:
Vorbereiten einer unelastischen Auflageschicht (20) mit einem Boden und einer Oberseite (36);
Vorbereiten einer Expansionsschicht (18) aus einem flexiblen Film und mit einer Bodenfläche (34) und einer Oberseite (32), wobei die Oberseite (32) der Expansionsschicht (18) die Oberseite der gedruckten Verdrahtungsplatine (10) bildet, und wobei eine Haftschicht (38) zwischen der Bodenfläche (34) der Expansionsschicht und der Oberseite (36) der Auflageschicht angeordnet ist, um die Unterseite der Expansionsschicht mit der Oberseite der Auflageschicht zu bonden, wobei sich die Expansionsschicht (18) im wesentlichen über die gesamte Oberseite der Auflageschicht (20) erstreckt;
Bilden einer dünnen Schicht (39) aus Polytetrafluorethylen durch Auftragen einer wäßrigen Emulsion aus Polytetrafluorethylen-Partikeln auf die Bodenfläche (34) der Expansionsschicht und Erhitzen der Emulsion für eine ausreichend lange Zeit und auf ausreichend hohe Temperaturen, um die Polytetrafluorethylen-Partikel in der dünnen Schicht (39) zu verschmelzen, wobei die dünne Schicht zwischen der Bodenfläche (34) und der Oberseite (36) an einer Chipträgerabdruckfläche (40) angeordnet wird, welche definiert ist durch den Bereich auf der Oberseite der gedruckten Verdrahtungsplatine (10) unterhalb der Position, an der der Boden des anschlußlosen Chipträgers aus Keramik befestigt wird, wobei die dünne Schicht (39) derart angeordnet wird, daß die Haftschicht (38) mit Ausnahme des unterhalb des Chipträgerprofils (40) befindlichen Bereichs mit der Bodenfläche gebondet wird.

13. Verfahren nach Anspruch 12, dadurch gekennzeichnet, daß die wäßrige Emulsion 55 bis 75 Gew.-% Polytetrafluorethylen-Partikel aufweist.

14. Verfahren nach Anspruch 12 oder 13, dadurch gekennzeichnet, daß die Polytetrafluorethylen-Partikel eine Oberflächenbeschichtung eines Benetzungsmittels aufweisen.

15. Verfahren nach einem der Ansprüche 12 bis 14, dadurch gekennzeichnet, daß die Partikelgröße der Polytetrafluorethylen-Partikel zwischen 0,1 µm und 0,25 µm liegt.

16. Verfahren nach einem der Ansprüche 12 bis 15, dadurch gekennzeichnet, daß die wäßrige Emulsion von Polytetrafluorethylen-Partikeln durch Silkscreen-Druck selektiv auf die Bodenfläche der Expansionsschicht (34) aufgetragen wird.

17. Verfahren nach einem der Ansprüche 12 bis 16, dadurch gekennzeichnet, daß die dünne Schicht (39) von verschmolzenem Polytetrafluorethylen eine Dicke zwischen 0,0002 cm und 0,0006 cm (0,0001 Zoll bis 0,0003 Zoll) aufweist.

## Revendications

1. Carte à câblage imprimé pour le montage d'un support (13) de microplaquette en céramique sans conducteur, ledit support (13) de microplaquette en céramique sans conducteur comportant un fond qui est fixé à la surface supérieure de ladite carte (10) à câblage imprimé, l'aire sur la surface supérieure de ladite carte (10) à câblage imprimé sous l'emplacement où lui est fixé le fond du support de microplaquette en céramique sans conducteur définissant une place occupée par le support de microplaquette, et ledit support (13) de microplaquette en céramique sans conducteur subissant une dilatation et une contraction, ladite carte (10) à câblage imprimé comprenant:
une couche de dilatation (18) réalisée à partir d'un film souple et ayant une surface inférieure (34) et une surface supérieure (32), la surface supérieure (32) de ladite couche de dilatation (18) formant la surface supérieure de ladite carte (10) à câblage imprimé;
une couche (20) de support rigide ayant un fond et une surface supérieure (36), ladite couche de dilatation (18) s'étendant sensiblement sur toute la surface supérieure de ladite couche (20) de support; et
une couche adhésive (38) disposée entre la surface inférieure (34) de ladite couche de dilatation et la surface supérieure (36) de ladite couche de support pour relier le fond de ladite couche de dilatation au sommet de ladite couche de support, des vides (40) étant prévus dans ladite couche adhésive (38) sous la place occupée par ledit support de microplaquette de telle sorte que la surface inférieure (34) de ladite couche de dilatation est reliée à la surface supérieure (36) de ladite couche de support sauf dans la surface située au-dessous de la place occupée par ledit support de microplaquette afin de permettre à ladite couche de dilatation (18) de se dilater et de se contracter avec ledit support (13) de microplaquette en céramique sans conducteur au cours de sa dilatation ou de sa contraction quelle que soit ladite couche (20) de support.

2. Carte à câblage imprimé selon la revendication 1, dans laquelle ladite couche de dilatation (18) comporte un film mince de polyimide.

3. Carte à câblage imprimé selon la revendication 1 ou 2, dans laquelle ladite couche de dilatation (18) a une épaisseur de 0,001 cm à 0,013 cm (0,0005 pouce à 0,005 pouce).

4. Carte à câblage imprimé selon la revendication 1, 2 ou 3, dans laquelle ladite couche de dilatation est un polyimide souple.

5. Carte à câblage imprimé selon l'une des revendications précédentes, dans laquelle ladite couche de support (20) comporte une pluralité de sous-couches stratifiées ensemble.

6. Carte à câblage imprimé selon la revendication 5, dans laquelle lesdites sous-couches comportent du métal, du verre, des céramiques ou une matière plastique rigide.

7. Carte à câblage imprimé selon la revendication 1, dans laquelle ladite couche adhésive comporte un adhésif sélectionné parmi le groupe consistant en préimprégné de polyimide et préimprégné d'époxy.

8. Carte à câblage imprimé selon la revendication 7, dans laquelle ladite couche adhésive a une épaisseur inférieure à 0,25 cm (0,10 pouce).

9. Carte à câblage imprimé selon l'une des revendications précédentes, comportant en outre un support (13) de microplaquette en céramique sans conducteur et des moyens de montage (42) pour fixer ledit support (13) de microplaquette en céramique sans conducteur à la surface supérieure (32) de ladite couche de dilatation (18) et dans laquelle la dilatation et la contraction de ladite couche de dilatation (18) avec la dilatation et la contraction dudit support (13) de microplaquette en céramique sans conducteur empêchent la fissuration desdits moyens de montage (42).

10. Carte à câblage imprimé selon l'une des revendications précédentes, comportant en outre une couche mince (39) de polytétrafluoréthylène disposée entre la surface inférieure (34) de ladite couche de dilatation et la surface supérieure (36) de ladite carte à câblage imprimé à la place occupée (40) par ledit support de microplaquette, ladite couche (39) de polytétrafluoréthylène étant placée de telle sorte que les moyens adhésifs (38) ne sont pas reliés au fond (34) de ladite couche de dilatation sous la place (40) occupée par ledit support de microplaquette.

11. Carte à câblage imprimé selon la revendication 10, dans laquelle ladite couche mince (39) de polytétrafluoroéthylène a une épaisseur comprise entre 0,0002 cm et 0,0006 cm (0,0001 pouce et 0,0003 pouce).

12. Procédé de formation d'une carte (10) à câblage imprimé pour le montage d'un support (13) de microplaquette en céramique sans conducteur comprenant les étapes suivantes:
préparation d'une couche (20) de support rigide ayant un fond et une surface supérieure (36);
préparation d'une couche de dilatation (18) réalisée à partir d'un film souple et ayant une surface inférieure (34) et une surface supérieure (32), la surface supérieure (32) de ladite couche de dilatation (18) formant la surface supérieure de ladite carte (10) à câblage imprimé, et une couche adhésive (38) étant disposée entre la surface inférieure (34) de ladite couche de dilatation et la surface supérieure (36) de ladite couche de support pour relier le fond de ladite couche de dilatation et le sommet de ladite couche de support, ladite couche de dilatation (18) s'étendant sensiblement sur toute la surface supérieure de ladite couche de support (20);
formation d'une couche mince (39) de polytétrafluoréthylène en appliquant une émulsion aqueuse de particules de polytétrafluoréthylène à la surface inférieure (34) de ladite couche de dilatation; et en chauffant ladite émulsion pendant un temps suffisant et à des températures suffisantes pour faire fondre les particules de polytétrafluoréthylène dans ladite couche mince (39), ladite couche mince étant disposée entre ladite surface inférieure (34) et ladite surface supérieure (36) à la place (40) occupée par le support de microplaquette qui est définie par l'aire sur la surface supérieure de ladite carte (10) à câblage imprimé sous l'emplacement où le fond dudit support de microplaquette en céramique sans conducteur lui est fixé, ladite couche mince (39) étant disposée de telle sorte que ladite couche adhésive (38) est reliée à ladite surface inférieure (34) sauf dans la zone située au-dessous de la place (40) occupée par ledit support de microplaquette.

13. Procédé selon la revendication 12, dans lequel ladite émulsion aqueuse comporte 55-75 pour cent en poids de particules de polytétrafluoréthylène.

14. Procédé selon la revendication 12 ou 13, dans lequel lesdites particules de polytétrafluoréthylène comportent un revêtement de surface ou un agent mouillant.

15. Procédé selon l'une des revendications 12 à 14, dans lequel la dimension des particules de polytétrafluoréthylène est comprise entre 0,1 µm et 0,25 µm.

16. Procédé selon l'une des revendications 12 à 15, dans lequel ladite émulsion aqueuse de particules de polytétrafluoréthylène est sélectivement appliquée à la surface inférieure (34) de ladite couche de dilatation par sérigraphie.

17. Procédé selon l'une des revendications 12 à 16, dans lequel ladite couche mince (39) en polytétrafluoréthylène fondu a une épaisseur comprise entre 0,0002 cm et 0,0006 cm (0,0001 pouce et 0,0003 pouce).
